# EUROPÄISCHE PATENTANMELDUNG

(11) **EP 4 734 679 A1**
(43) Veröffentlichungstag der Anmeldung: **29.04.2026**
(21) Anmeldenummer: 24208009.1
(22) Anmeldetag: 22.10.2024
(51) Int. Cl.: H05K 7/14, H01L 25/11, H05K 7/20

(54) **LEISTUNGSMODUL FÜR EINEN STROMRICHTER**

(71) Anmelder: Innomotics GmbH, 90441 Nürnberg (DE)
(72) Erfinder: Tannert, Maximilian, 91757 Treuchtlingen (DE)
(74) Vertreter: Siemens Patent Attorneys

(57) **Zusammenfassung**

Die Erfindung betrifft ein Leistungsmodul (1) für einen Stromrichter (2) mit einem druckkontaktierbaren Halbleiter (13). Zur Verbesserung des Leistungsmodul (1) wird vorgeschlagen, dass das Leistungsmodul (1) ein Rohr (11) und zwei Druckarme (12) umfasst, wobei die Druckarme (12) jeweils am Rohr (11) angeordnet sind, wobei der druckkontaktierbare Halbleiter (13) zwischen den zwei Druckarmen (12) angeordnet ist, wobei das Leistungsmodul (1) mindestens ein Federelement aufweist, die derart angeordnet ist, eine Kontaktkraft auf eine Anschlussfläche (20) des druckkontaktierbaren Halbleiters (13) auszuüben. Weiter betrifft die Erfindung einen Stromrichter (2) mit einem derartigen Leistungsmodul (1), wobei das Leistungsmodul (1) im Stromrichter (2) angeordnet ist. Die Erfindung betrifft ferner einen elektrischen Antrieb (3) mit einem derartigen Stromrichter (2), wobei der elektrische Antrieb (3) mindestens eine elektrische Maschine (5) aufweist, wobei die elektrische Maschine (5) mit Wechselspannungsanschlüssen (61) des Stromrichters (2) verbunden ist. Weiter betrifft die Erfindung ein Energieversorgungssystem (4) mit einem derartigen Leistungsmodul (1) und/oder einem derartigen Stromrichter (2), wobei das Energieversorgungssystem (4) ferner eine Energiequelle (40) und einen elektrischen Verbraucher (41) aufweist, wobei das Leistungsmodul (1) derart angeordnet ist, einen Energiefluss zwischen der Energiequelle (40) und des elektrischen Verbrauchers (41) zu beeinflussen.

## Beschreibung

Die Erfindung betrifft ein Leistungsmodul für einen Stromrichter mit einem druckkontaktierbaren Halbleiter. Ferner betrifft die Erfindung einen Stromrichter mit einem derartigen Leistungsmodul. Die Erfindung betrifft weiter einen elektrischen Antrieb mit einem derartigen Stromrichter sowie ein Energieversorgungssystem mit einem derartigen Leistungsmodul und/oder einem derartigen Stromrichter.

Ein Stromrichter verwendet Halbleiter, um durch Schalten von Strömen zwischen elektrischen Potentialen elektrische Energie umzuformen. Die Umformung kann beispielsweise von Gleichspannung zu Wechselspannung oder umgekehrt, sowie zwischen Gleichspannungen mit unterschiedlicher Spannungshöhe oder zwischen Wechselspannungen unterschiedlicher Frequenz geschehen.

Druckkontaktierbare Halbleiter erfordern eine Kontaktierung ihrer Kontaktflächen mit einem bestimmten Druck bzw. einer bestimmten Kraft. Ein Beispiel derartiger druckkontaktierbarer Halbleiter sind Scheibenzellen. Dabei werden beispielsweise Dioden, Thyristoren, GTO oder IGCT Halbleiter in druckkontaktierte Scheibenzellen montiert. Diese haben ein gasdichtes Keramikgehäuse, wobei die elektrischen Kontakte an den Stirnseiten der zylinderförmigen Scheibenzelle als vernickelten Kupferscheiben ausgebildet sind. Zwischen diesen Scheiben befindet sich ein großflächiger Siliziumchip. Die Stirnseite der Scheibenzelle bildet somit eine Anschlussfläche des druckkontaktierbaren Halbleiters.

Dieser Aufbau wird unter anderem durch einen äußeren Aufbau mittels eines Spannverbands fixiert. Dabei muss durch den Spannverband eine bestimmte Kraft auf die Stirnflächen der druckkontaktierbaren Halbleiter, also auf die Anschlussflächen des druckkontaktierbaren Halbleiters, aufgebracht werden. Der gesamte Aufbau ist in sich lose und wird durch einen den Spannverband zusammengehalten.

Stromrichter unterscheidet man beispielsweise hinsichtlich ihrer Funktion in Ausführungen in Zweipunkttechnologie und Dreipunkttechnologie. Bei der Zweipunkttechnologie wird der Wechselspannungsanschluss mit einem von zwei Zwischenkreispotentialen verbunden. Bei der Dreipunkttechnologie steht neben den beiden Zwischenkreispotentialen noch das Potential eines Mittelpunktes, also in Summe drei elektrische Potentiale für die Verbindung mit dem Wechselspannungsanschluss zur Verfügung. Darüber hinaus gibt es noch Technologien mit einer größeren Anzahl an elektrischen Potentialen, die mit dem Wechselspannungsanschluss verbunden werden können.

Der verwendete Begriff des Rohres bezieht sich nicht nur auf einen Körper mit einem Hohlraum. Der Begriff Rohr umfasst im Folgenden auch einen Stab oder eine Stange, der bzw. die keinen Hohlraum im Innern aufweist. Darüber hinaus beschränkt sich der Begriff Rohr nicht auf einen bestimmten Querschnitt. Das Rohr umfasst damit auch Körper mit einem eckigen Querschnitt, wie beispielsweise einem rechteckigen, quadratischen, dreieckigen oder mehreckigen Querschnitt. Ebenso umfasst der Begriff Rohr auch Querschnitte in beliebiger Form wie beispielsweise in runder oder ovaler Form oder auch eine Kombination aus den genannten Querschnitten.

Der Erfindung liegt die Aufgabe zugrunde, einen derartigen Spannverband zu verbessern.

Diese Aufgabe wird durch ein Leistungsmodul für einen Stromrichter mit einem Rohr, zwei Druckarmen und einem druckkontaktierbaren Halbleiter gelöst, wobei die Druckarme jeweils am Rohr angeordnet sind, wobei der druckkontaktierbare Halbleiter zwischen den zwei Druckarmen angeordnet ist, wobei das Leistungsmodul mindestens ein Federelement aufweist, das derart angeordnet ist, eine Kontaktkraft auf eine Anschlussfläche des druckkontaktierbaren Halbleiters auszuüben. Ferner wird diese Aufgabe durch einen Stromrichter mit einem derartigen Leistungsmodul gelöst, wobei das Leistungsmodul im Stromrichter angeordnet ist.

Weitere vorteilhafte Ausgestaltungen der Erfindung sind in den abhängigen Ansprüchen angegeben.

Der Erfindung liegt unter anderem die Erkenntnis zugrunde, dass sich ein Leistungsmodul durch den vorgeschlagenen Aufbau deutlich verbessern lässt. Dieses Leistungsmodul weist mindestens einen druckkontaktierbaren Halbleiter auf, der zwischen zwei Druckarmen angeordnet ist. Dabei erzeugt ein Federelement eine Kraft bzw. einen Druck, beispielweise eine Kraft im Bereich von 44kN bis 55kN, auf die Anschlussflächen des druckkontaktierbaren Halbleiters. Ist der druckkontaktierbare Halbleiter beispielsweise als Scheibenzelle ausgebildet, so bilden die Stirnseiten dieser Scheibenzelle die Anschlussflächen des druckkontaktierbaren Halbleiters. Dabei kann die Kraft, die den Druck auf den druckkontaktierbaren Halbleiter erzeugt, von dem Rohr und/oder dem Druckarm erzeugt werden. Mit anderen Worten bilden das Rohr und/oder der Druckarm dann das Federelement des Leistungsmoduls. Alternativ oder ergänzend kann zur Druckerzeugung auch eine Tellerfeder verwendet werden, die den Druck vollständig aufbringt oder die bereits vorhandenen, für die Druckerzeugung verwendeten Komponenten Rohr und/oder Druckarm unterstützt. Dabei kann die Tellerfeder analog zu den druckkontaktierbaren Halbleitern zwischen den Druckarmen angeordnet sein oder, alternativ kann die Tellerfeder am Rohr befestigt sein, dass die Kraft von der Tellerfeder über den Druckarm auf den druckkontaktierbaren Halbleiter wirkt.

Für den Aufbau des Leistungsmoduls wird nur genau ein Rohr benötigt, das die Gegenkraft der auf den druckkontaktierbaren Halbleiter oder die druckkontaktierbaren Halbleiter aufgebrachten Kräfte aufnimmt bzw. zur Verfügung stellt. Das Rohr ist dann vorzugsweise mittig in dem Leistungsmodul angeordnet. Für die Stabilität hat es sich als günstig erwiesen, ein Rohr zu verwenden, das im Innern einen Hohlraum aufweist, da dieses einer Biegebeanspruchung besonders gut widerstehen kann. Damit kann das Rohr neben dem Aufbringen der Gegenkraft für die Druckkontaktierung auch in vorteilhafter Weise für die Kühlung, insbesondere für die Kühlung der Halbleiter, verwendet werden. Dazu wird das Rohr im Innern von einer Kühlflüssigkeit durchströmt. Der Kanal für die Kühlflüssigkeit kann dabei beispielsweise durch das Material des Rohres gebildet werden. Darüber hinaus hat es sich als vorteilhaft erwiesen. Im Innern des Rohres zwei Kammern vorzusehen, die jeweils einen Kanal für die Kühlflüssigkeit bilden. So können im Innern des Rohres zwei Kanäle für den Hinlauf und den Rücklauf des Kühlwassers angeordnet werden. Anstelle das Materials zur Bildung des Kanals für die Kühlflüssigkeit zu nutzen, kann im Rohr auch ein Schlauch oder mehrere Schläuche zum Durchströmen mit Kühlflüssigkeit angeordnet werden. Somit kann die Anzahl der Kühlkanale auf den Anwendungsfall auf einfache Art angepasst werden.

Mit der Nähe des Rohres zu den Halbleitern kann die Kühlflüssigkeit dann, beispielsweise mittels Schläuche an die Halbleiter herangeführt werden. Neben der Funktion für den mechanischen Aufbau und/oder dem Übertragen von Kühlflüssigkeit kann das Rohr darüber hinaus auch zur Befestigung weiterer Komponenten wie Sensoren, Ansteuerschaltungen, Teile des Kühlsystems, Kommunikationselemente, Stecker, Steuer- oder Regelvorrichtung genutzt werden.

Ferner ist es möglich, mehrere druckkontaktierbare Halbleiter mechanisch in Reihe anzuordnen, so dass diese eine Art Turm bilden. Dazu werden diese druckkontaktierbaren Halbleiter zu einer Säule gestapelt und zwischen den Druckarmen angeordnet. Es hat sich dabei als vorteilhaft erwiesen, in der Säule, beispielsweise zwischen den Halbleitern, ein Zwischenelement anzuordnen. Dieses verbessert den elektrischen Kontakt und kann beispielsweise auch zur besseren Kühlung beitragen. Dazu kann dies Zwischenelement derart ausgebildet sein, mit einer Flüssigkeit durchflossen zu werden. In einer besonders vorteilhaften Ausgestaltung wird das Rohr mit der Kühlflüssigkeit durchströmt. Dabei weist das Zwischenelement eine Verbindung zum Rohr auf, über die Flüssigkeit zwischen Rohr und Zwischenelement zirkulieren kann. Gleichzeitig kann das Zwischenelement der Stromleitung dienen und ein elektrisches Potential wie beispielsweise den des Wechselspannungsanschluss zur Anschlussstelle herauszuführen. Dabei ist das Zwischenelement als elektrischer Leiter ausgebildet.

Ein vorteilhafter Druck, der einen guten Kompromiss für die Funktion und die Befestigung des druckkontaktierbaren Halbleiters und der mechanischen Belastung der Komponenten darstellt, ist eine Kraft in der Größenordnung von 44kN bis 55kN. Dies umfasst eine Kraft im Bereich zwischen 30kN und 70kN. Für Halbleiter mit einer geringeren Toleranz erstreckt sich dieser Bereich der Kraft vorzugsweise von 40kN bis 60kN.

Im Vergleich zu einem heute üblichen Aufbau mit Gussrahmen, GFK Platten und Bolzen werden deutlich weniger Bauteile für das vorgeschlagene Leistungsmodul benötigt. Zudem reduziert sich das Gewicht des Leistungsmodul teilweise sogar deutlich gegenüber heute bekannten Aufbauten mit Spannverband.

Des Weiteren kann bei dem vorgeschlagenen Aufbau das Rohr nicht nur zum Aufbringen der Gegenkraft genutzt werden, sondern kann in vorteilhafter Weise Teil des Kühlsystems sein und Kühlflüssigkeit transportieren. Über Kühlmodule und entsprechenden Schläuchen kann die Kühlung der Halbleiter, insbesondere von Scheibenzellen, erfolgen. Dazu wird eine derartiges Kühlmodul mit dem Halbleiter zwischen den Druckarmen angeordnet. Bei der Verwendung mehrerer Halbleiter in einer Säule zwischen den Druckarmen kann das Kühlmodul gleichzeitig als Zwischenelement dienen und, beispielsweise aufgrund einer ebenen Oberfläche, den Kontakt zwischen den Halbleitern verbessern bzw. optimieren.

Alternativ oder ergänzend ist es auch möglich, mehr Säulen von Halbleitern oder auch einzelne druckkontaktierbare Halbleiter zwischen den Druckarmen anzuordnen. Die Kraft verteilt sich dann gleichmäßig von dem Druckarm auf die einzelnen Halbleiter bzw. Säulen von Halbleitern.

In einer vorteilhaften Ausgestaltung kann das Leistungsmodul auch mehrerer, also mindestens zwei Paare von Druckelementen aufweisen. Dabei werden die Halbleiter, alleine oder mehrere, in einer Säule zwischen zwei der Druckarme angeordnet. Für einen dreiphasigen Stromrichter hat es sich als besonders vorteilhaft erwiesen, drei Paare von Druckelementen vorzusehen.

Dabei weist jede Phase des Stromrichters mindestens zwei Halbleiter für einen Aufbau in Zweipunkttechnologie auf, die zwischen den Paaren der Druckarme angeordnet sein können. Für die Ausbildung in Dreipunkttechnologie werden in vorteilhafter Weise für eine Phase mehr Säulen verwendet. Insbesondere die Verwendung von drei Säulen hat sich für die Realisierung einer Phase eines Stromrichters in Dreipunkttechnologie als günstig erwiesen. Dabei weisen jeweils zwei der drei Säulen mindestens vier druckkontaktierbare Halbleiter auf. Eine dritte Säule kann dann je nach Ausgestaltung des Stromrichters mit nur zwei Halbleitern oder auch mit vier Halbleitern ausgestattet sein. Mit anderen Worten weist die dritte Säule in dieser Ausführung zwei oder vier druckkontaktierbare Halbleiter auf. Die Verwendung mehrerer Paare von Druckelementen macht die Wartung und den Austausch einzelner Komponenten in nur einer Phase besonders einfach, da nur der in einer Säule vorhandene Druck gelöst werden muss und die übrigen Elemente aufgrund des Drucks in den übrigen Druckarmen sicher fixiert sind. Um die Spannungsfestigkeit des Stromrichters weiter zu erhöhen, können weitere druckkontaktierbare Halbleiter in der Säule elektrisch in Reihe angeordnet werden.

Die Tellerfeder kann auch als Tellerfederpaket ausgebildet sein, bei dem mehrere Tellerfeder eine Kraft erzeugen. Diese Kraft ist gut justierbar, so dass sich ein Tellerfederpaket im Besonderen für die Anwendung in einem Leistungsmodul bzw. in einem Stromrichter eignet.

Mit dem vorgeschlagenen Aufbau kann eine Vielzahl unterschiedlicher Stromrichtertopologien, sowohl in Zweipunkttechnologie als auch in Dreipunkttechnologie realisiert werden. Dabei können im Wesentlichen die gleichen Komponenten verwendet werden. Dies reduziert die Teilevielfalt bei der Realisierung unterschiedlicher Stromrichtertopologien. Dadurch ist der Stromrichter oder auch eine ganze Familie von Stromrichtern deutlich aufwandsärmer mit geringeren Kosten herstellbar.

Für Stromrichter im Bereich ab einem Megawatt (1 MW oder 1 MVA) hat sich die Verwendung von Halbleitern als vorteilhaft erwiesen, die in einer Scheibenzelle ausgebildet sind. Die entsprechenden Halbleiter mit einer Stromtragfähigkeit von mehr als einem Kiloampere (1 kA) werden auch als Leistungshalbleiter bezeichnet. Durch die hohe Leistungsdichte dieser Bauteile eignen sie sich im Besonderen für den Leistungsbereich oberhalb von einem Megawatt. Die Möglichkeit, das Rohr für die Kühlung, also beispielsweise das Heranführen und Verteilen der Kühlflüssigkeit zu verwenden macht den Aufbau besonders leistungsfähig und dazu besonders kompakt, da auf weitere Komponenten zum Leiten und Verteilen der Kühlflüssigkeit verzichtet werden kann.

Diese Anordnung kann beispielsweise für die Realisierung eines elektrischen Antriebs genutzt werden, wobei ein Stromrichter mit einem oder mehreren derartigen Leistungsmodulen eine elektrische Maschine steuert und antreibt. Durch die Anordnung kann ein besonders leistungsfähiger Antrieb mit Versorgungsspannungen im Mittelspannungsbereich, d.h. Spannungen größer als 1000 V mit geringem Platzbedarf und zu geringen Kosten bereitgestellt werden. Des Weiteren eignen sich sowohl die Leistungsmodule als auch die Stromrichter dazu, einen Energiefluss in einem Energieversorgungssystem zu beeinflussen und zu steuern.

Bei einer vorteilhaften Ausgestaltung der Erfindung wird das Federelement durch eine Tellerfeder, den Druckarm und/oder das Rohr gebildet wird. Bei dieser Ausgestaltung kann die Druckerzeugung für die Druckkontaktierung teilweise oder vollständig durch bereits vorhandene Elemente des Leistungsmoduls erzeugt werden. Auf ein weiteres Bauteil mit einer Federwirkung, wie beispielsweise eine Tellerfeder kann verzichtet werden. Es hat sich gezeigt, dass durch eine entsprechende Verspannung die Hebelarme eine definierte Kraft im Bereich von 40 kN bis 60 kN auf die druckkontaktierbaren Halbleiter ausüben können. Weiter hat sich gezeigt, dass der Druck, der dieser Kraft entspricht, auch über den gesamten Betriebstemperaturbereich des Leistungsmodul sicher eingehalten werden kann. Besonders vorteilhaft ist es, wenn die Kraft von Druckarm über die entsprechenden Hebelarme und dem Rohr ausgeübt werden. Es hat sich gezeigt, dass sich dadurch thermische Effekte im Rohr und den Druckarmen derart kompensieren lassen, dass sich über einen großen Temperaturbereich eine nahezu konstante Kraft bzw. ein nahezu konstanter Druck auf die druckkontaktierbaren Halbleiter erzeugen lässt. Um die Temperaturabhängigkeit weiter zu reduzieren hat es sich als vorteilhaft erwiesen, wenn zusätzlich zu der Auslegung, bei der das Rohr und/oder die Druckarme eine Kraft bzw. einen Druck auf den druckkontaktierbaren Halbleiter erzeugen, das Leistungsmodul zusätzlich noch eine Tellerfeder aufweist, die zwischen den Druckarmen angeordnet ist oder über dessen Kraft über die Druckarme auf die druckkontaktierbaren Halbleiter wirkt.

Bei einer weiteren vorteilhaften Ausgestaltung der Erfindung ist das Rohr hohl ausgebildet. Neben der bereits erwähnten Nutzung zum Führen der Kühlflüssigkeit hat die hohle Ausführung des Rohres weitere Vorteile. Durch die hohle Ausführung des Rohres erhält das Rohr eine gute Federwirkung. Damit kann das Rohr teilweise oder vollständig die Funktion des Federelementes übernehmen. Darüber hinaus hat sich gezeigt, dass die Federwirkung des hohlen Rohres eine deutlich geringere thermische Abhängigkeit aufweist als ein massives Rohr. Des Weiteren ist zu erwähnen, dass durch die hohle Ausgestaltung das Gewicht und die Kosten des Rohres verbessert werden.

Bei einer weiteren vorteilhaften Ausgestaltung der Erfindung weisen die Druckarme jeweils Hebelarme auf, die sternförmig um ein Zentrum des jeweiligen Druckarms angeordnet sind, wobei die Druckarme jeweils im Bereich des Zentrums mit dem Rohr verbunden sind. Dabei können die Hebelarme die Aufgabe des Federelementes vollständig oder teilweise übernehmen. Zwischen den Hebelarmen unterschiedlicher Druckarme ist dann jeweils eine Säule angeordnet, wobei die Säulen jeweils einen oder mehrere druckkontaktierbare Halbleiter aufweisen. Durch die sternförmige Anordnung der Hebelarme ergibt sich für alle Säulen eine nahezu gleiche Kraft, die von den Hebelarmen aufgebracht wird. Damit lässt sich auf einfache Weise eine gleiche Kraft auf die druckkontaktierbaren Halbleiter erzeugen.

Gleichzeitig können damit sämtliche Bauteile eines Stromrichters oder mehrerer Stromrichter, die für ihre Anordnung eine Druckkontaktierung benötigen, in einem Leistungsmodul zusammengefasst werden. Dieses Leistungsmodul kann besonders platzsparend realisiert werden, wobei es zudem eine gute Zugänglichkeit der einzelnen Komponenten des Leistungsmoduls sicherstellt.

Bei einer weiteren vorteilhaften Ausgestaltung der Erfindung weisen die Druckarme jeweils genau drei Hebelarme auf, wobei jeweils zwischen den Hebelarmen eines ersten der zwei Druckarme und den Hebelarmen eines zweiten der zwei Druckarme jeweils mindestens ein druckkontaktierbarer Halbleiter angeordnet ist. Dabei hat es sich insbesondere für einen dreiphasigen Stromrichter in Zweipunkttechnologie als günstig erwiesen, die jeweiligen Phasen des Stromrichters in einem Aufbau, insbesondere in einer Säule zwischen zwei Hebelarmen der beiden Druckarme anzuordnen. Dabei ist es vorteilhaft, wenn bei einem dreiphasigen Stromrichter in Zweipunkttechnologie die Druckarme jeweils genau drei Hebelarme aufweisen. Bei dieser Ausführung werden dann die einzelnen Phasen des Stromrichters zwischen einem der Hebelarme eines ersten der Druckarme und einem Hebelarm eines zweiten der Druckarme angeordnet. Bei einem Stromrichter in Zweipunkttechnologie weist eine Phase mindestens zwei druckkontaktierbare Halbleiter auf. Für einen Stromrichter in Dreipunkttechnologie hat es sich als günstig erwiesen, die erforderlichen Halbleiter auf die drei Hebelarme aufzuteilen. Dabei weist eine erste Säule vier schaltbare druckkontaktierbare Halbleiterschalter, wie beispielsweise IGCTs, IGBTs oder Thyristoren, auf, eine zweite Säule weist die zu den vier schaltbaren druckkontaktierbaren Halbleiterschaltern antiparallel angeordneten vier nichtschaltbaren druckkontaktierbaren Halbleiterschalter auf. Eine dritte Säule weist dann die zur Bildung des Mittelpunkts notwendigen druckkontaktierbaren Halbleiter auf. Diese Anordnung vereint alle erforderlichen Halbleiter einer Phase und ist damit zum einen besonders platzsparend und gleichzeitig ist die Zugänglichkeit der einzelnen Komponenten, insbesondere der Halbleiter und der Ansteuerschaltungen, gegenüber bekannten Aufbauten deutlich verbessert.

Gerade für den dreiphasigen Stromrichter in Dreipunkttechnologie kann durch den vorgeschlagenen Aufbau für jede Phase eine besonders kompakte, stabile und für die einzelnen Komponenten gut zugängliche Lösung realisiert werden, die alle Anforderungen an die Sicherheit und den zuverlässigen Betrieb, wie dauerhafte Sicherstellung der Kontaktkraft an den Anschlussflächen des druckkontaktierbaren Halbleiters sicher einhält.

Bei einer weiteren vorteilhaften Ausgestaltung der Erfindung weisen die Hebelarme jeweils paarweise den gleichen Winkel zueinander auf. Bei dieser Anordnung verteilen sich die Kräfte derart gleichmäßig, dass als resultierende Kraft nur eine Komponente in der Ausdehnungsrichtung des Rohres entsteht. Dadurch kann das Rohr besonders klein und leicht ausgeführt sein, da keine Kräfte auftreten, die eine Biegebeanspruchung des Rohres bewirken. Dadurch ist der Aufbau nur geringen mechanischen Belastungen ausgesetzt, die in einer hohen Lebensdauer und geringem Materialaufwand resultieren.

Bei einer weiteren vorteilhaften Ausgestaltung der Erfindung weist das Rohr eine Vorrichtung zur Aufnahme einer Flüssigkeit in das Innere des Rohres auf. Dabei kann das Rohr als Teil des Kühlsystems genutzt werden, um Kühlflüssigkeit in die Nähe der Halbleiter zu befördern. Die durch die Verlustleitung der Halbleiter entstehende Wärme kann beispielsweise durch Kühldosen aufgenommen werden, die zusätzlich zu den Halbleitern zwischen den Hebelarmen bzw. den Druckarmen angeordnet werden. Diese Kühldosen können beispielsweise in der Säule der Halbleiter, insbesondere zwischen zwei Halbleiter, angeordnet sein. Dabei wirkt das Rohr des Leistungsmodul als Teil des Kühlsystems des Stromrichters und trägt somit zu einem platzsparenden Aufbau und guter Zugänglichkeit zu den vorhandenen Komponenten bei, da auf die Anordnung von separaten Rohren zum Leiten der Kühlflüssigkeit verzichtet werden kann.

Bei einer weiteren vorteilhaften Ausgestaltung der Erfindung sind zwischen den zwei Druckarmen genau drei Säulen angeordnet, wobei eine erste Säule der drei Säulen vier schaltbare druckkontaktierbare Halbleiter aufweist, wobei eine zweite Säule der drei Säulen mindestens vier nichtschaltbare druckkontaktierbare Halbleiter aufweist, wobei eine dritte Säule der drei Säulen mindestens zwei nichtschaltbare druckkontaktierbare Halbleiter aufweist. Damit lässt sich in einfache Weise eine Phase eines Stromrichters in Dreipunkttechnologie realisieren. Ein besonderer Vorteil besteht darin, dass sich mit diesem Aufbau auf einfache Weise ein Dreipunkt-Stromrichter mit drei Gleichspannungspotentialen auf einfache Weise realisieren lässt. Gleichzeitig kann für jeden der verwendeten Halbleiter dabei der erforderliche Anpressdruck durch den Aufbau zuverlässig realisiert werden.

Im Folgenden wird die Erfindung anhand der in den Figuren dargestellten Ausführungsbeispiele näher beschrieben und erläutert. Es zeigen:
- FIG 1: eine bekannte Anordnung von druckkontaktierbaren Halbleitern,
- FIG 2 bis FIG 5: Ausführungsbeispiele eines Leistungsmoduls,
- FIG 6, FIG 7: jeweils einen druckkontaktierbaren Halbleiter,
- FIG 8: einen elektrischen Antrieb und
- FIG 9: ein Energieversorgungssystem.

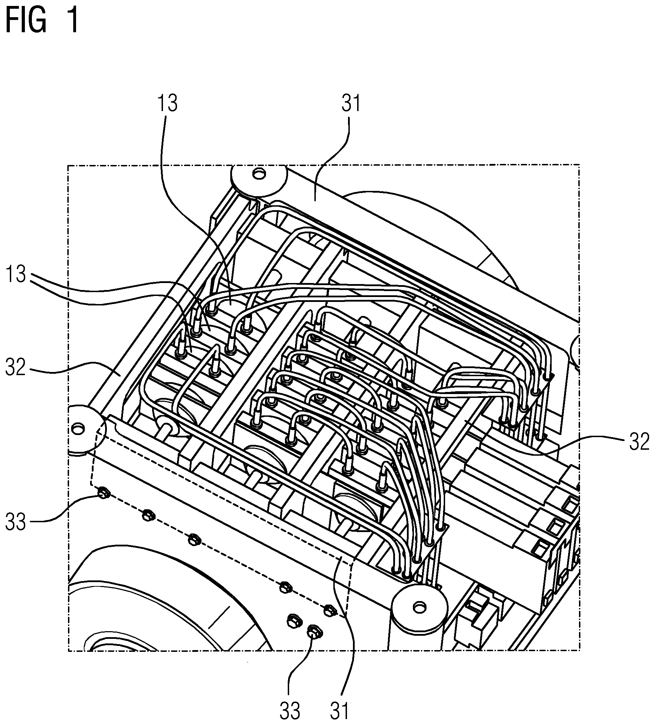

Die FIG 1 zeigt eine bekannte Anordnung, bei der druckkontaktierbare Halbleiter 13 in einem Spannverband angeordnet und elektrisch verbunden sind. Die druckkontaktierbaren Halbleiter 13 werden von GFK Platten 32 mittels Bolzen 33 zusammengehalten.

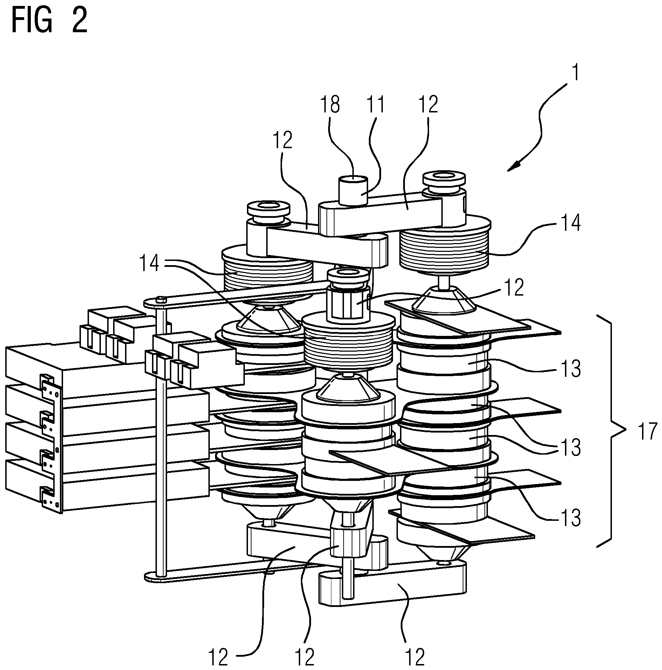

Die FIG 2 zeigt ein Ausführungsbeispiel eines Leistungsmoduls 1 für die Anordnung von drucckontaktierbaren Halbleitern 13. Die druckkontaktierbaren Halbleiter 13 sind, ggf. mit weiteren Komponenten wie einer Kühldose 22, in einer Säule 17 zwischen zwei Druckarmen 12 angeordnet. Für jede Säule 17 von druckkontaktierbaren Halbleitern 13 sind in diesem Ausführungsbeispiel jeweils zwei Druckarme 12 vorgesehen. Die Druckarme 12 sind mit einem Rohr 11 verbunden. Zur Erzeugung einer Kraft bzw. eines Drucks auf die in dieser Figur nicht näher dargestellten Anschlussflächen 20 des druckkontaktierbaren Halbleiters 13 wird zwischen den Druckarmen 12 eine Tellerfeder 14 oder alternativ ein Tellerfederpaket mit einer Vielzahl von Tellerfedern 14 angeordnet. Das Rohr 11 stellt die Gegenkraft für die durch die Tellerfedern 14 erzeugten Kraft zur Verfügung und wird entsprechend mechanisch dimensioniert. Dabei kann das Rohr 11 hohl ausgeführt werden. Dies erlaubt die Nutzung des Rohres 11 als Teil des Kühlsystems, wenn es von Kühlflüssigkeit durchströmt wird. Dazu kann am Rohr 11 eine Vorrichtung 18 zur Aufnahme von Flüssigkeit vorgesehen werden.

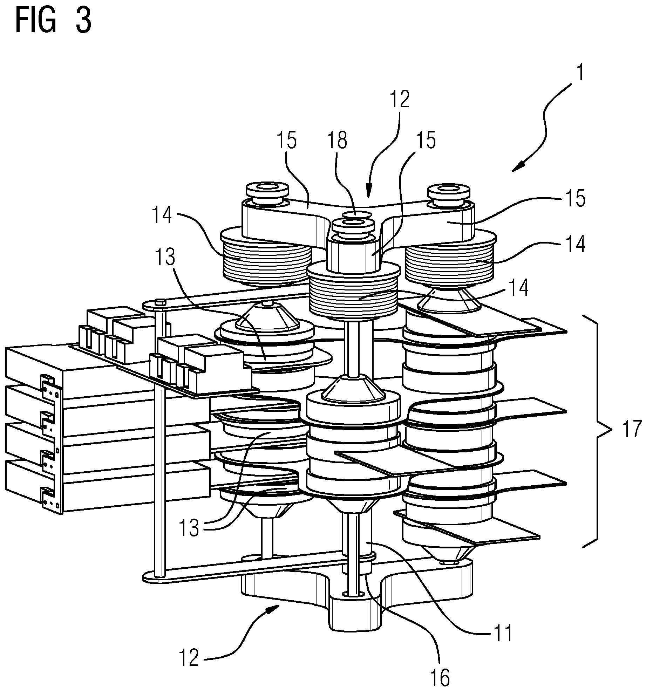

Die FIG 3 zeigt ein weiteres Ausführungsbeispiel des Leistungsmoduls 1. Zur Vermeidung von Wiederholungen wird auf die Beschreibung zur FIG 2 sowie auf die dort eingeführten Bezugszeichen verwiesen. Anstelle einer Vielzahl von Druckarmen 12 verwendet dieses Ausführungsbeispiel nur genau zwei Druckarme 12. Zur Aufnahme mehrerer Säulen 17 weisen die Druckarme mehrere Hebelarme 15 auf. Die Befestigung der Druckarme 12 am Rohr 11 erfolgt vorzugsweise im Zentrum 16 des Druckarms 12.

Die übrigen Komponenten, insbesondere die Ausgestaltung der Säulen 17 und des Rohres 11 können wie in FIG 2 beschrieben ausgeführt sein.

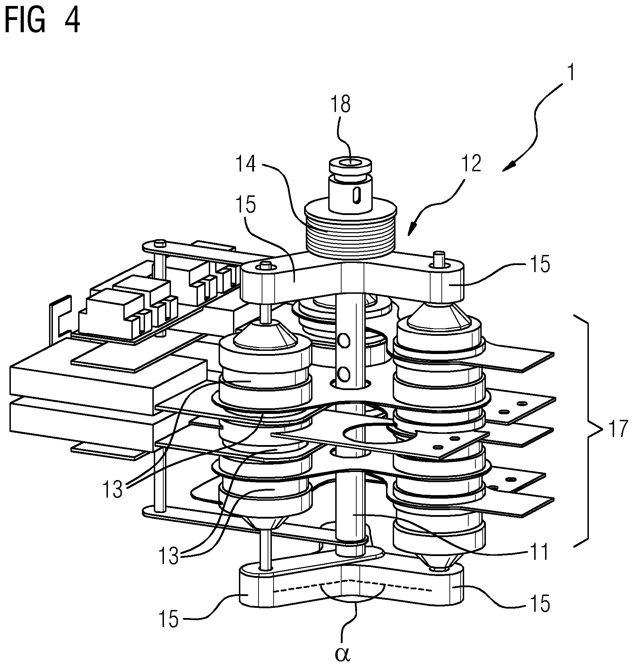

Die FIG 4 zeigt ein weiteres Ausführungsbeispiel des Leistungsmoduls 1. Zur Vermeidung von Wiederholungen wird auf die Beschreibung zu den Figuren 2 und 3, sowie auf die dort eingeführten Bezugszeichen verwiesen. Anstelle für jede Säule bzw. für jeden Hebelarm eine separate Tellerfeder 14 vorzusehen, kann auch alternativ nur eine Tellerfeder 14 verwendet werden, die über die einzelnen Hebelarme 15 einer der Druckarme 12 die durch sie erzeugte Kraft auf die Säulen 17 und insbesondere auf die Anschlussflächen 20 der druckkonatktierbaren Halbleiter 13 überträgt.

Besonders vorteilhaft für die Verteilung der Kräfte hat es sich erwiesen, wenn ein Winkel α zwischen zwei der Hebelarme 15 für alle Hebelarme 15 gleich ist. Bei der Ausführung mit drei Hebelarmen 15 beträgt der Winkel dann α = 120°. Dies gilt im übrigen auch für die Ausgestaltung des Ausführungsbeipiels nach FIG 3.

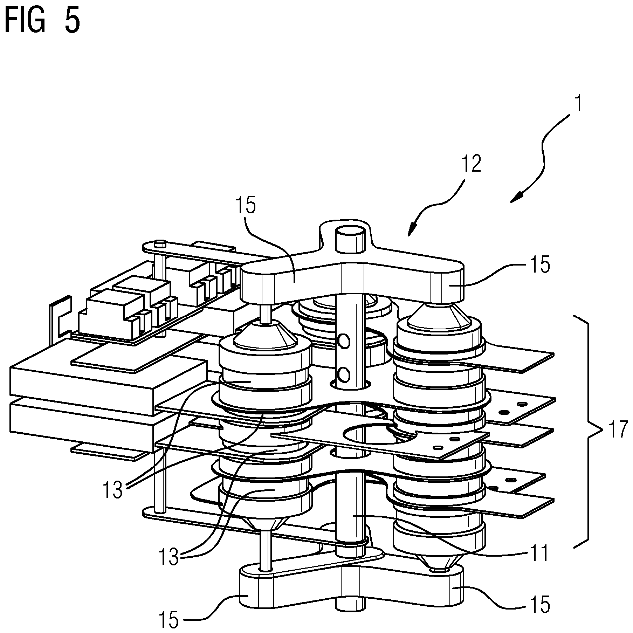

Die FIG 5 zeigt ein weiteres Ausführungsbeispiel des Leistungsmoduls 1. Zur Vermeidung von Wiederholungen wird auf die Beschreibung zu den Figuren 2 bis 4 sowie auf die dort eingeführten Bezugszeichen verwiesen. Im Wesentlichen entspricht dieses Ausführungsbeispiel dem Ausführungsbeispiel der FIG 4. Jedoch kann auf die dortige Tellerfeder 14 verzichtet werden. Dies wird dadurch erreicht, dass die Funktion des Federelements durch das Rohr 11 und/oder Druckarme 12 übernommen wird. Dabei bewirkt ein Elastizitätsmodul des Rohres 11 eine Kraft auf die druckkontaktierbaren Halbleiter 13. Insbesondere bei einer hohlen Ausbildung des Rohres ergibt sich eine von der Temperatur nahezu unabhängige Kraftkomponente. Alternativ oder ergänzend erzeugen auch die Hebelarme 15 der jeweiligen Druckarme 12 eine Kraft auf die druckkontaktierbaren Halbleiter 13. Einer der Vorteile dieser Anordnung besteht darin, dass die für die Druckkontaktierung erforderliche Kraft auch ohne Tellerfeder zuverlässig und dauerhaft durch das Rohr 11 und/oder die Hebelarme 15 erzeugt werden kann.

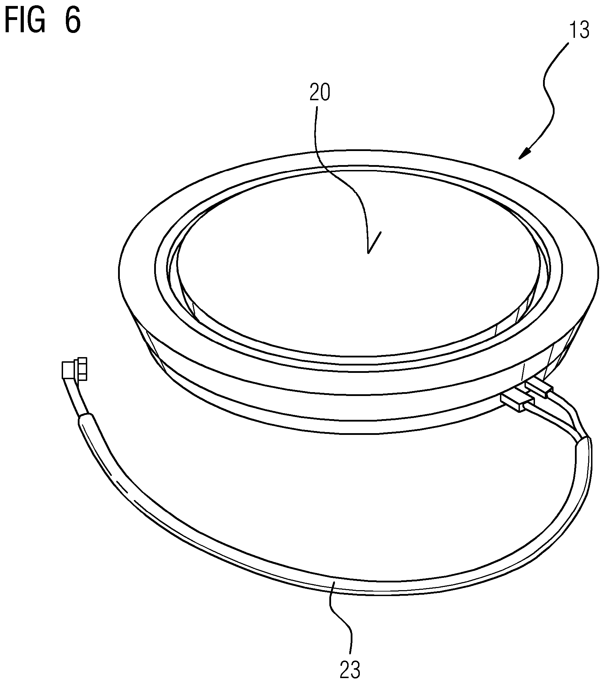

Die FIG 6 zeigt einen druckkontaktierbaren Halbleiter 13. Bei dieser Darstellung handelt es sich beispielhaft um einen Thyristor. Dieser ist als Scheibenzelle ausgeführt. Er ist zylinderförmig ausgebildet, wobei die Stirnseiten des Zylinders jeweils eine Anschlussfläche 20 des druckkontaktierbaren Halbleiters 13 bilden. Des Weiteren weist der druckkontaktierbare Halbleiter 13 eine Verbindung 23 zur Übertragung von Ansteuersignalen an den druckkonatktierbaren Halbleiter 13 auf.

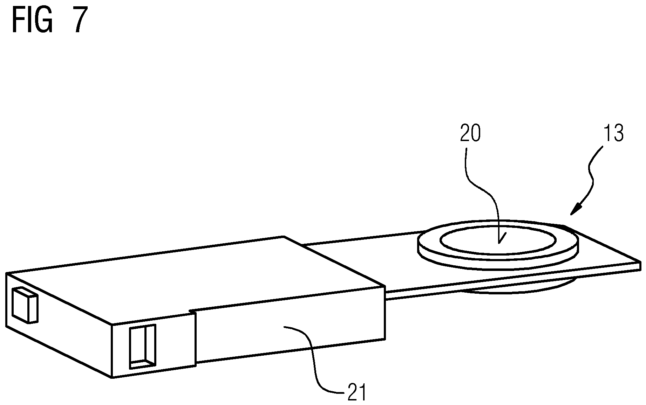

Die FIG 7 zeigt einen weiteren druckkontaktierbaren Halbleiter 13, der in diesem Beispiel als IGCT Halbleiter ausgebildet ist. Auch dieser weist einen zylinderförmigen Körper auf, dessen Stirnseiten die leistungsseitigen Anschlussflächen 20 des druckkontaktierbaren Halbleiters 13 bilden. Dabei kann der Stromfluss durch die Scheibenzelle geschaltet werden. Des weiteren ist die Ansteuerbaugruppe 21 dargestellt, welche das Schaltverhalten des IGCTs steuert. Im Gegensatz zu einem Thyristor kann mit dem IGCT auch ein Strom abgeschaltet werden. Mit diesem Bauelement können selbstgeführte Stromrichterschaltungen, insbesondere für den hohen Leistungsbereich und im hohen Spannungsbereich wie dem Mittelspannungsbereich, realisiert werden.

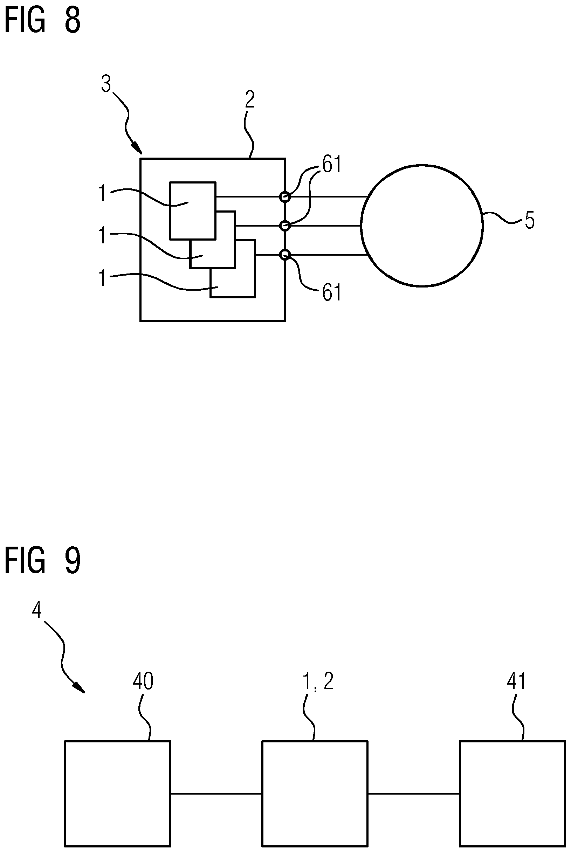

Die FIG 8 zeigt einen elektrischen Antrieb 10. Dabei ist eine elektrische Maschine 5 mit den Wechselspannungsanschlüssen 61 des Stromrichters 2 verbunden. Zur Erzeugung einer Wechselspannung an den Wechselspannungsanschlüssen 61 weist der Stromrichter für jede Phase, also für jeden Wechselspannungsanschluss beispielsweise ein Leistungsmodul 1 auf. Damit lässt sich auf einfache Weise ein Stromichter 2 in Dreipunkttechnologie realisieren. Ebenso sind die Leistungsmodule 1 und/oder ein aus diesen Leistungsmodulen 1 aufgebauter Stromrichter 2 als Teil eines Energieversorgungssystems 4 nutzbar. Dies ist in FIG 9 dargestellt. Mit Hilfe der Leistungsmodule 1 bzw. des Stromrichters 2 lässt sich ein Energiefluss zwischen einer Energiequelle 40 und mindestens einem elektrischen Verbraucher 41 des Energieversorgungssystems 4 beeinflussen.

### Bezugszeichenliste

- 1: Leistungsmodul
- 2: Stromrichter
- 3: Elektrischer Antrieb
- 4: Energieversorgungssystem
- 5: elektrische Maschine

- 11: Rohr
- 12: Druckarm
- 13: druckkontaktierbarer Halbleiter
- 14: Tellerfeder
- 15: Hebelarm
- 16: Zentrum des druckkontaktierbaren Halbleiters (13)
- 17: Säule
- 18: Vorrichtung zur Aufnahme von Flüssigkeit

- 20: Anschlussfläche des druckkontaktierbaren Halbleiters (13)
- 21: Ansteuerbaugruppe des druckkontaktierbaren Halbleiters (13)
- 22: Kühldose
- 23: Verbindung zur Übertragung von Ansteuersignalen

- 31: Gussrahmen
- 32: GFK Platte
- 33: Bolzen

- 40: Energiequelle
- 41: elektrischer Verbraucher

- 60: Kondensator
- 61: Wechselspannungsanschluss
- 62: Zwischenkreisanschluss
- 63: Mittelpunkt

- 131: schaltbarer, druckkontaktierbarer Halbleiter
- 132: nichtschaltbarer, druckkontaktierbarer Halbleiter
- 133: weiterer, druckkontaktierbarer Halbleiter

- 171: erste Säule
- 172: zweite Säule
- 173: dritte Säule

- α: Winkel zwischen zwei der Hebelarme (15)

## Patentansprüche

1. Leistungsmodul (1) für einen Stromrichter (2), aufweisend
- ein Rohr (11),
- zwei Druckarme (12) und
- einen druckkontaktierbaren Halbleiter (13),
wobei die Druckarme (12) jeweils am Rohr (11) angeordnet sind, wobei der druckkontaktierbare Halbleiter (13) zwischen den zwei Druckarmen (12) angeordnet ist, wobei das Leistungsmodul (1) mindestens ein Federelement aufweist, die eine Kontaktkraft auf eine Anschlussfläche (20) des druckkontaktierbaren Halbleiters (13) ausübt.

2. Leistungsmodul (1) nach Anspruch 1, wobei das Federelement durch eine Tellerfeder (14), den Druckarm (12) und/oder das Rohr (11) gebildet wird.

3. Leistungsmodul (1) nach einem der Ansprüche 1 oder 2, wobei das Rohr (11) hohl ausgebildet ist.

4. Leistungsmodul (1) nach einem der Ansprüche 1 bis 3, wobei die Druckarme (12) jeweils Hebelarme (15) aufweisen, die sternförmig um ein Zentrum (16) des jeweiligen Druckarms (12) angeordnet sind, wobei die Druckarme (12) jeweils im Bereich des Zentrums (16) mit dem Rohr (11) verbunden sind.

5. Leistungsmodul (1) nach einem der Ansprüche 1 bis 4, wobei die Druckarme (12) jeweils genau drei Hebelarme (15) aufweisen, wobei jeweils zwischen den Hebelarmen (15) eines ersten der zwei Druckarme (12) und den Hebelarmen (15) eines zweiten der zwei Druckarme (12) jeweils mindestens ein druckkontaktierbarer Halbleiter (13) angeordnet ist.

6. Leistungsmodul (1) nach einem der Ansprüche 1 bis 5, wobei die Hebelarme (15) jeweils paarweise den gleichen Winkel (α) zueinander aufweisen.

7. Leistungsmodul (1) nach einem der Ansprüche 1 bis 6, wobei das Rohr (11) eine Vorrichtung zur Aufnahme einer Flüssigkeit in das Innere des Rohres (11) aufweist.

8. Leistungsmodul (1) nach einem der Ansprüche 1 bis 7, wobei zwischen den zwei Druckarmen (12) genau drei Säulen (17) angeordnet sind, wobei eine erste Säule (171) der drei Säulen (17) vier schaltbare druckkontaktierbare Halbleiter (131) aufweist, wobei eine zweite Säule (172) der drei Säulen (17) mindestens vier nichtschaltbare druckkontaktierbare Halbleiter (132) aufweist, wobei eine dritte Säule (173) der drei Säulen (17) mindestens zwei nichtschaltbare druckkontaktierbare Halbleiter (132) aufweist.

9. Stromrichter (2) mit mindestens einem Leistungsmodul (1) nach einem der Ansprüche 1 bis 8, wobei das Leistungsmodul (1) im Stromrichter (2) angeordnet ist.

10. Stromrichter (2) nach Anspruch 9, wobei das Rohr (11) des Leistungsmodul (1) Teil des Kühlsystems des Stromrichters (2) ist.

11. Stromrichter (11) nach einem der Ansprüche 9 oder 10, wobei der Stromrichter (2) als dreiphasiger Dreipunktstromrichter ausgebildet ist und drei Leistungsmodule (1) gemäß Anspruch 8 aufweist.

12. Elektrischer Antrieb (3) mit einem Stromrichter (2) nach einem der Ansprüche 9 bis 11, wobei der elektrische Antrieb (3) mindestens eine elektrische Maschine (5) aufweist, wobei die elektrische Maschine (5) mit Wechselspannungssanschlüssen (61) des Stromrichters (2) verbunden ist.

13. Energieversorgungssystem (4), aufweisend
- mindestens eine Energiequelle (40),
- mindestens einen elektrischen Verbraucher (41) und
- ein Leistungsmodul (1) nach einem der Ansprüche 1 bis 8 und/oder einem Stromrichter (2) nach einem der Ansprüche 9 bis 11,
wobei das Leistungsmodul (1) derart angeordnet ist, einen Energiefluss zwischen der Energiequelle (40) und des elektrischen Verbrauchers (41) zu beeinflussen.
